# EUROPEAN PATENT APPLICATION

(11) **EP 3 940 795 A1**
(43) Date of publication of application: **19.01.2022**
(21) Application number: 20822585.4
(22) Date of filing: 04.06.2020
(51) Int. Cl.: H01L 31/0224

(54) **SOLAR CELL SHEET, SOLAR CELL PANEL AND SCREEN PRINTING PLATE**

(30) Priority: 14.06.2019 CN 201920898401 U
(71) Applicant: Longi Solar Technology (Taizhou) Co., Ltd., Taizhou, Jiangsu 225300 (CN)
(72) Inventor: WANG, Binyuan, Taizhou, Jiangsu 225300 (CN); KONG, Suoyuan, Taizhou, Jiangsu 225300 (CN); TAO, Xiaobo, Taizhou, Jiangsu 225300 (CN); SHEN, Honglei, Taizhou, Jiangsu 225300 (CN)
(74) Representative: Loo, Chi Ching
(86) International application number: PCT/CN2020/094408
(87) International publication number: WO 2020/248895

(57) **Abstract**

A solar cell, a solar cell panel and a screen printing plate, wherein the solar cell includes a light facing face (1) and a shadow face (2), the light facing face (1) is provided with a plurality of front electrodes (10), and the shadow face (2) is provided with a plurality of back electrodes (20); the plurality of front electrodes (10) are arranged separately in a length direction to form a front-electrode strip (11); the plurality of back electrodes (20) are arranged separately in the length direction to form a back-electrode strip (22); a center line of the front-electrode strip (11) in the length direction is a first center line; a center line of the back-electrode strip (22) in the length direction is a second center line; a projection of the first center line in a first direction and a projection of the second center line in the first direction coincide, wherein the first direction refers to a direction from the light facing face (1) to the shadow face (2); and a projection of a starting point of the front-electrode strip (11) in the first direction and a projection of a starting point of the back-electrode strip (22) in the first direction coincide. When the solar cells are connected by series welding by using a photovoltaic solder strip, hidden cracking at the starting welding spot between the solar cells and the photovoltaic solder strip is prevented, which effectively increases the efficiency of the assembling of the solar cells.

## Description

The present application claims the priority of the Chinese patent application filed on June 14th, 2019 before the Chinese Patent Office with the application number of 201920898401.1 and the title of "SOLAR CELL SHEET, SOLAR CELL PANEL AND SCREEN PRINTING PLATE", which is incorporated herein in its entirety by reference.

### TECHNICAL FIELD

The present application relates to the technical field of solar-energy photovoltaics, and particularly relates to a solar cell, a solar cell panel and a screen printing plate.

### BACKGROUND

With the development of the technique of photovoltaics, crystalline-silicon solar cells have been extensively utilized as an environment-friendly and renewable energy source.

Currently, the electrodes are fabricated by printing silver slurry, aluminum slurry etc. on the front and back faces of a solar cell. Generally, the electrodes on the light facing face (the face directly irradiated by the sunlight) of the solar cell are referred to as the front electrodes, and the electrodes on the shadow face (the face not directly irradiated by the sunlight) of the solar cell are referred to as the back electrodes. When the solar cells are connected by series welding, the photovoltaic solder strip connects the front electrodes of one solar cell to the back electrodes of another solar cell.

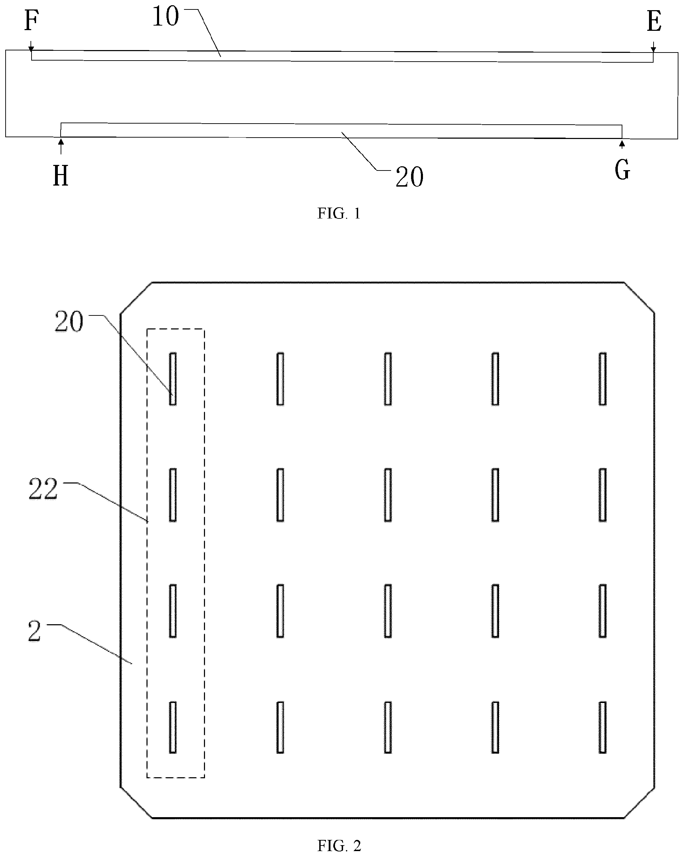

Referring to FIG. 1, FIG. 1 shows a schematic diagram of a solar cell in the prior art. As shown in FIG. 1, the starting point E/F of the front electrodes 10 on the solar cell and the starting point G/H of the back electrodes 20 have different distances from the edge of the solar cell. Because the front electrodes affect the light receiving area and the convergence efficiency of the solar cell, it is generally configured that the distance from the starting point of the front electrodes in the length direction to the edge of the solar cell is smaller, and the distance from the starting point of the back electrodes in the length direction to the edge of the solar cell is larger.

However, when the solar cells are connected by series welding, because the distances from the starting points of the front electrodes and of the back electrodes to the edge of the cell are different, in the welding between the solar cell and the photovoltaic solder strip, the stresses generated at the starting point of the front electrodes and at the starting point of the back electrodes cannot offset with each other in the positive and negative directions, whereby hidden cracking is generated at the starting welding spot between the solar cells and the photovoltaic solder strip, which affects the efficiency of the assembling of the solar cells.

### SUMMARY

In view of the above disadvantages of the prior art, the present application solves the problem of hidden cracking at the starting welding spot between the solar cells and the photovoltaic solder strip. The present application provides a solar cell, a solar cell panel and a screen printing plate.

In order to solve the above technical problem, the present application provides a solar cell, wherein the solar cell comprises a light facing face and a shadow face, the light facing face is provided with a plurality of front electrodes, and the shadow face is provided with a plurality of back electrodes;
the plurality of front electrodes are arranged separately in a length direction to form a front-electrode strip;
the plurality of back electrodes are arranged separately in the length direction to form a back-electrode strip;
a center line of the front-electrode strip in the length direction is a first center line;
a center line of the back-electrode strip in the length direction is a second center line;
a projection of the first center line in a first direction and a projection of the second center line in the first direction coincide, wherein the first direction refers to a direction from the light facing face to the shadow face; and
a projection of a starting point of the front-electrode strip in the first direction and a projection of a starting point of the back-electrode strip in the first direction coincide.

Preferably, a quantity of the front-electrode strip and a quantity of the back-electrode strip are both multiple.

Preferably, the plurality of front-electrode strips are evenly distributed on the light facing face, and the plurality of back-electrode strips are evenly distributed on the shadow face.

Preferably, a quantity of the front electrodes of the front-electrode strip is greater than or equal to a quantity of the back electrodes of the back-electrode strip.

Preferably, the plurality of back electrodes include first back electrodes and a second back electrode, wherein the first back electrodes refer to back electrodes adjacent to the starting point of the back-electrode strip, and the second back electrode refers to a back electrode provided between the first back electrodes; and
lengths of the first back electrodes and a length of the second back electrode are unequal or equal.

Preferably, among the plurality of back electrodes, spacings between two neighboring instances of the back electrodes are equal or unequal.

Preferably, a width of the front electrodes is less than or equal to a width of the back electrodes, and/or, a length of the front electrodes is less than or equal to a length of the back electrodes.

In the second aspect, the present application further discloses a solar cell panel, wherein the solar cell panel is formed by the solar cell stated above.

In the third aspect, the present application further discloses a screen printing plate, the screen printing plate being used in cooperation with the solar cell stated above, wherein the screen printing plate is provided with a printing region, the printing region is provided with a notch, and a shape of the notch matches with shapes of the back electrodes on the solar cell or shapes of the front electrodes on the solar cell.

The present application has the following advantages:

in the embodiments of the present application, because the projection of the starting point of the front-electrode strip in the first direction and the projection of the starting point of the back-electrode strip in the first direction coincide, when the solar cells are connected by series welding by using a photovoltaic solder strip, the welding stresses generated at the starting point of the front-electrode strip and at the starting point of the back-electrode strip can offset with each other in the positive and negative directions, which prevents hidden cracking at the starting welding spot between the solar cells and the photovoltaic solder strip, thereby increasing the efficiency of the assembling of the solar cells.

The above description is merely a summary of the technical solutions of the present application. In order to more clearly know the elements of the present application to enable the implementation according to the contents of the description, and in order to make one of the above and other purposes, features and advantages of the present application more apparent and understandable, particular embodiments of the present application will be provided below.

### BRIEF DESCRIPTION OF THE DRAWINGS

In order to more clearly illustrate the technical solutions of the embodiments of the present application or the prior art, the figures that are required to describe the embodiments or the prior art will be briefly introduced below. Apparently, the figures that are described below are embodiments of the present application, and a person skilled in the art can obtain other figures according to these figures without paying creative work.
FIG. 1 is a schematic diagram of a solar cell in the prior art;
FIG. 2 is a schematic diagram of the back electrodes of a solar cell according to the present application;
FIG. 3 is a schematic diagram of the solar cell in the other direction according to the present application; and
FIG. 4 is a schematic diagram of another solar cell according to the present application.

### Description of the reference numbers:

1-light facing face, 2-shadow face, 10-front electrodes, 11-front-electrode strip, 20-back electrodes, 22-back-electrode strip, 201-first back electrodes, 202-second back electrodes, A/B-starting point of front-electrode strip, C/D-starting point of back-electrode strip, E/F-starting point of front electrodes, and G/H-starting point of back electrodes.

### DETAILED DESCRIPTION

In order to further illustrate the embodiments, drawings are provided in the present application. Those drawings are part of the disclosure of the present application, and they are mainly used to illustrate the embodiments, and may explain the operation principle of the embodiments in cooperation with the relevant description of the description. By referring to those contents, a person skilled in the art can comprehend other feasible embodiments and the advantages of the present application. The elements in the drawings are not drawn to scale, and similar reference numbers generally denote similar elements.

The present application will be described further with reference to the drawings and the particular embodiments.

The embodiments of the present application provide a solar cell, wherein the solar cell comprises a light facing face and a shadow face, the light facing face is provided with a plurality of front electrodes, and the shadow face is provided with a plurality of back electrodes; the plurality of front electrodes are arranged separately in a length direction to form a front-electrode strip; the plurality of back electrodes are arranged separately in the length direction to form a back-electrode strip; a center line of the front-electrode strip in the length direction is a first center line; a center line of the back-electrode strip in the length direction is a second center line; a projection of the first center line in a first direction and a projection of the second center line in the first direction coincide, wherein the first direction refers to a direction from the light facing face to the shadow face; and a projection of a starting point of the front-electrode strip in the first direction and a projection of a starting point of the back-electrode strip in the first direction coincide.

In the embodiments of the present application, because the projection of the starting point of the front-electrode strip in the first direction and the projection of the starting point of the back-electrode strip in the first direction coincide, when the solar cells are connected by series welding by using a photovoltaic solder strip, the welding stresses generated at the starting point of the front-electrode strip and at the starting point of the back-electrode strip can offset with each other in the positive and negative directions, which prevents hidden cracking at the starting welding spot between the solar cells and the photovoltaic solder strip, thereby effectively increasing the efficiency of the assembling of the solar cells.

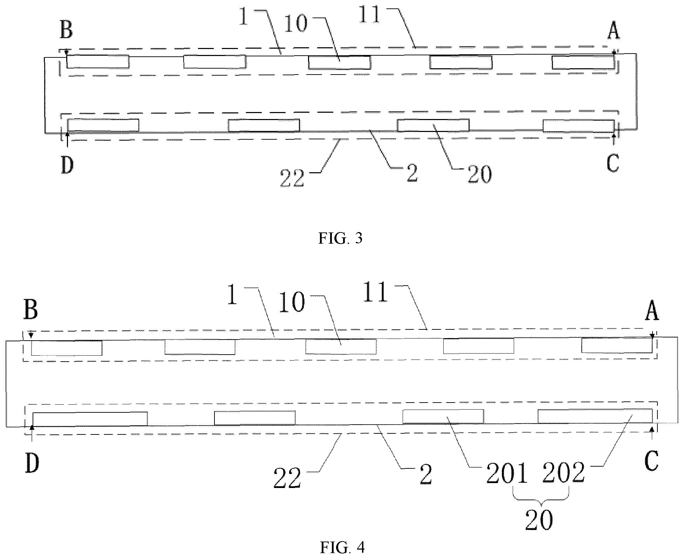

Referring to FIG. 2, FIG. 2 shows a schematic diagram of the back electrodes of the solar cell according to an embodiment of the present application. Referring to FIG. 3, FIG. 3 shows a schematic diagram of the solar cell in the other direction according to an embodiment of the present application. As shown in the drawings, the solar cell comprises a light facing face 1 and a shadow face 2, the light facing face 1 is provided with a plurality of front electrodes 10, and the shadow face 2 is provided with a plurality of back electrodes 20; the plurality of front electrodes 10 are arranged separately in the length direction to form a front-electrode strip 11; the plurality of back electrodes 20 are arranged separately in the length direction to form a back-electrode strip 22; the center line of the front-electrode strip 11 in the length direction is a first center line; the center line of the back-electrode strip 22 in the length direction is a second center line; the projection of the first center line in the first direction and the projection of the second center line in the first direction coincide, wherein the first direction refers to the direction from the light facing face 1 to the shadow face 2; and the projection of the starting point A/B of the front-electrode strip 11 in the first direction and the projection of the starting point C/D of the back-electrode strip 22 in the first direction coincide.

In the embodiments of the present application, when the solar cells are connected by series welding by using a photovoltaic solder strip, the welding stresses generated at the starting point A/B of the front-electrode strip 11 and at the starting point C/D of the back-electrode strip can offset with each other in the positive and negative directions, which prevents hidden cracking at the starting welding spot between the solar cells and the photovoltaic solder strip, thereby effectively increasing the efficiency of the assembling of the solar cells.

In practical applications, the starting point of the front-electrode strip 11 may be set to be any one of the point A or the point B. It can be understood that, if the point A is set to be the starting point of the front-electrode strip 11, then certainly the point B is the tailing point of the front-electrode strip. In the same manner, the above-described rule of defining the starting point also applies to the starting point C/D of the back-electrode strip 22.

In practical applications, because the solar cells are connected by series welding by using a photovoltaic solder strip, assuming that the photovoltaic solder strip is welded from the point A of the front-electrode strip 11 as the starting point, then when the photovoltaic solder strip and the back-electrode strip 22 are being welded, the welding may be performed from the point D as the starting point. The starting points of the front-electrode strip and the back-electrode strip, and the starting points of the welding between the front-electrode strip and the back-electrode strip and the photovoltaic solder strip, are not particularly limited in the present application.

Moreover, the first direction refers to the direction from the light facing face 1 to the shadow face 2, i.e., the direction perpendicular to the light facing face 1 and the shadow face 2, and the direction here is not limited to pointing to the shadow face 2 from the light facing face 1, and may also be the direction pointing to the light facing face 1 from the shadow face 2.

In the embodiments of the present application, in order to improve the esthetics of the solar cell and the evenness of convergence, and simplify the welding process, the spacings between the neighboring front electrodes 10 of the front-electrode strip 11 may be set to be equal or unequal, and the spacings between the neighboring back electrodes 20 of the back-electrode strip 22 may be set to be equal or unequal. Certainly, a person skilled in the art may set the spacings between the neighboring front electrodes and between the neighboring back electrodes according to practical demands, which is not particularly limited in the embodiments of the present application.

In the embodiments of the present application, the front-electrode strip 11 and the back-electrode strip 22 may be a plurality of front-electrode strips 11 and a plurality of back-electrode strips 22, which can effectively reduce the convergence distance of the solar cell, thereby increasing the convergence efficiency of the solar cell.

In practical applications, the plurality of front-electrode strips 11 are evenly distributed on the light facing face 1, and the plurality of back-electrode strips 22 are evenly distributed on the shadow face 2. That cannot only improve the uniformity of the converging current of the solar cell, but also can improve the aesthetic degree of the solar cell. Furthermore, that can also simplify the process of welding the solar cell with the photovoltaic solder strip.

Preferably, the quantity of the front electrodes 10 of the front-electrode strip 11 is greater than or equal to the quantity of the back electrodes 20 of the back-electrode strip 22.

In practical applications, in order to increase the light receiving area of the solar cell and increase the convergence efficiency of the solar cell, generally it is configured that the quantity of the front electrodes 10 of the front-electrode strip 11 is greater than the quantity of the back electrodes 20 of the back-electrode strip 22. Certainly, in order to improve the esthetics of the solar cell and the convenience of the welding of the photovoltaic solder strip, it may also be configured that the quantity of the front electrodes 10 of the front-electrode strip 11 is equal to the quantity of the back electrodes 20 of the back-electrode strip 22, which is not particularly limited in the embodiments of the present application.

Referring to FIG. 4, FIG. 4 shows a schematic diagram of another solar cell according to an embodiment of the present application. As shown in FIG. 4, the plurality of back electrodes 20 include first back electrodes 201 and second back electrodes 202, wherein the first back electrodes 201 refer to the back electrodes adjacent to the starting point of the back-electrode strip 22, and the second back electrodes 202 refer to the back electrodes provided between the first back electrodes 201; and the lengths of the first back electrodes 201 and of the second back electrodes 202 are unequal or equal.

In the embodiments of the present application, when the lengths of the first back electrodes 201 and of the second back electrodes 202 are equal, the spacings between the plurality of back electrodes 20 of the back-electrode strip 22 may be adjusted, so that the projection of the starting point C/D of the back-electrode strip 22 in the first direction and the projection of the starting point A/B of the front-electrode strip 11 in the first direction coincide, which prevents hidden cracking at the starting welding spot between the solar cells and the photovoltaic solder strip, thereby effectively increasing the efficiency of the assembling of the solar cells.

When the lengths of the first back electrodes 201 and of the second back electrodes 202 are unequal, because the first back electrodes 201 are the back electrodes adjacent to the starting point of the back-electrode strip 22, and the second back electrodes 202 are the back electrodes provided between the first back electrodes 201, the lengths of the first back electrodes 201 may be set to be greater than the lengths of the second back electrodes 202, so that the projection of the starting point of the back-electrode strip 22 in the first direction and the projection of the starting point of the front-electrode strip 11 in the first direction coincide, which prevents hidden cracking at the starting welding spot between the solar cells and the photovoltaic solder strip, thereby effectively increasing the efficiency of the assembling of the solar cells.

Certainly, a person skilled in the art may also set that the lengths of the first back electrodes 201 are less than the lengths of the second back electrodes 202, and by adjusting the spacings between the first back electrodes 201 and the second back electrodes 202, enable the projection of the starting point of the back-electrode strip 22 in the first direction and the projection of the starting point of the front-electrode strip 11 in the first direction to coincide, which prevents hidden cracking at the starting welding spot between the solar cells and the photovoltaic solder strip, thereby effectively increasing the efficiency of the assembling of the solar cells.

In the embodiments of the present application, it is merely required to ensure that the projection of the starting point of the front-electrode strip 11 in the first direction and the projection of the starting point of the back-electrode strip 22 in the first direction coincide. Whether that is realized particularly by increasing or reducing the spacings between the back electrodes 20, or by increasing or reducing the lengths of the back electrodes 20, may be configured particularly by a person skilled in the art according to circumstances, and is not particularly limited in the embodiments of the present application.

Preferably, among the plurality of back electrodes 20, the spacings between two neighboring back electrodes 20 are equal or unequal.

In practical applications, when the consumption of the silver slurry of the front electrodes and the back electrodes is constant, that, among the plurality of back electrodes 20, the spacings between two neighboring back electrodes 20 are equal or unequal means that the spacings between two neighboring back electrodes 20 may be equally increased or reduced, or the spacings between two neighboring back electrodes 20 may be unequally increased or reduced, to realize the technical effect that the projection of the starting point of the front-electrode strip in the first direction and the projection of the starting point of the back-electrode strip in the first direction coincide, which prevents hidden cracking at the starting welding spot between the solar cells and the photovoltaic solder strip, thereby effectively increasing the efficiency of the assembling of the solar cells. Certainly, a person skilled in the art may also set the spacings between the neighboring back electrodes to be equal or unequal according to actual situations, which is not particularly limited in the embodiments of the present application.

Preferably, the width of the front electrodes 10 is less than or equal to the width of the back electrodes 20, and/or, the length of the front electrodes 10 is less than or equal to the length of the back electrodes 20.

In the embodiments of the present application, by configuring that the width of the front electrodes 10 is less than the width of the back electrodes 20, and/or, the length of the front electrodes 10 is less than the length of the back electrodes 20, the light receiving area of the solar cell is increased, thereby improving the photovoltaic conversion rate of the solar cell. In practical applications, it may also be configured that the width of the front electrodes 10 is equal to the width of the back electrodes 20, and the length of the front electrodes 10 is equal to the length of the back electrodes 20, so that the front electrodes and the back electrodes can be completely welded simultaneously by using an automatic welding tool, which simplifies the welding process, and improves the reliability of the welding. Certainly, a person skilled in the art may also set the particular lengths and widths of the front electrodes 10 and the back electrodes 20 according to practical demands, which is not particularly limited in the embodiments of the present application.

In conclusion, the solar cell according to the embodiments of the present application has the following advantage:

In the embodiments of the present application, because the projection of the starting point of the front-electrode strip in the first direction and the projection of the starting point of the back-electrode strip in the first direction coincide, when the solar cells are connected by series welding by using a photovoltaic solder strip, the welding stresses generated at the starting point of the front-electrode strip and at the starting point of the back-electrode strip can offset with each other in the positive and negative directions, which prevents hidden cracking at the starting welding spot between the solar cells and the photovoltaic solder strip, thereby effectively increasing the efficiency of the assembling of the solar cells.

The embodiments of the present application further provide a solar cell panel, wherein the solar cell panel may particularly be formed by the solar cell stated above.

In the embodiments of the present application, because the projection of the starting point of the front-electrode strip on the solar cell in the first direction and the projection of the starting point of the back-electrode strip in the first direction coincide, when the solar cells are connected by series welding by using a photovoltaic solder strip into the solar cell panel, the welding stresses generated at the starting point of the front-electrode strip and at the starting point of the back-electrode strip can offset with each other in the positive and negative directions, which prevents hidden cracking at the starting welding spot between the solar cells and the photovoltaic solder strip, thereby effectively increasing the efficiency of the assembling of the solar cells.

The embodiments of the present application further provide a screen printing plate, the screen printing plate being used in cooperation with the solar cell stated above. Particularly, the screen printing plate is provided with a printing region, the printing region is provided with a notch, and a shape of the notch matches with a shape of the back electrodes on the solar cell or a shape of the front electrodes on the solar cell.

In practical applications, the shape of the printing region of the screen printing plate may match with the shape of the solar cell, to improve the convenience of the matching between the printing region and the solar cell. Because the printing region is provided with a notch, and the shape of the notch is the same as the shape of the front electrodes/the back electrodes on the solar cell, after the printing region and the solar cell have been adhered, by brush-coating silver slurry, aluminum slurry etc. on the printing region, the silver slurry and the aluminum slurry can flow via the notch onto the solar cell, to form the front electrodes and the back electrodes on the solar cell.

In the present application, because the screen printing plate is provided with a printing region, the printing region is provided with a notch, and the shape of the notch matches with the shape of the back electrodes on the solar cell or the shape of the front electrodes on the solar cell, the front electrodes and the back electrodes of the above-described solar cell can be printed by using the screen printing plate. Because the projection of the starting point of the front-electrode strip on the solar cell in the first direction and the projection of the starting point of the back-electrode strip in the first direction coincide, when the solar cells are connected by series welding by using a photovoltaic solder strip into the solar cell panel, the welding stresses generated at the starting point of the front-electrode strip and at the starting point of the back-electrode strip can offset with each other in the positive and negative directions, which prevents hidden cracking at the starting welding spot between the solar cells and the photovoltaic solder strip, thereby effectively increasing the efficiency of the assembling of the solar cells.

Although the present application has been particularly described and introduced with reference to the preferable embodiments, a person skilled in the art should understand that various variations may be made to the present application in format and details without departing from the spirit and the scope of the present application defined by the appended claims, all of which fall within the protection scope of the present application.

The above-described device embodiments are merely illustrative, wherein the units that are described as separate components may or may not be physically separate, and the components that are displayed as units may or may not be physical units; in other words, they may be located at the same location, and may also be distributed to a plurality of network units. Part or all of the modules may be selected according to the actual demands to realize the purposes of the solutions of the embodiments. A person skilled in the art can understand and implement the technical solutions without paying creative work.

The "one embodiment", "an embodiment" or "one or more embodiments" as used herein means that particular features, structures or characteristics described with reference to an embodiment are included in at least one embodiment of the present application. Moreover, it should be noted that here an example using the wording "in an embodiment" does not necessarily refer to the same embodiment.

The description provided herein describes many concrete details. However, it can be understood that the embodiments of the present application may be implemented without those concrete details. In some of the embodiments, well-known processes, structures and techniques are not described in detail, so as not to affect the understanding of the description.

In the claims, any reference signs between parentheses should not be construed as limiting the claims. The word "comprise" does not exclude elements or steps that are not listed in the claims. The word "a" or "an" preceding an element does not exclude the existing of a plurality of such elements. The present application may be implemented by means of hardware comprising several different elements and by means of a properly programmed computer. In unit claims that list several devices, some of those devices may be embodied by the same item of hardware. The words first, second, third and so on do not denote any order. Those words may be interpreted as names.

## Claims

1. A solar cell, **characterized in that** the solar cell comprises a light facing face and a shadow face, the light facing face is provided with a plurality of front electrodes, and the shadow face is provided with a plurality of back electrodes;
the plurality of front electrodes are arranged separately in a length direction to form a front-electrode strip;
the plurality of back electrodes are arranged separately in the length direction to form a back-electrode strip;
a center line of the front-electrode strip in the length direction is a first center line;
a center line of the back-electrode strip in the length direction is a second center line;
a projection of the first center line in a first direction and a projection of the second center line in the first direction coincide, wherein the first direction refers to a direction from the light facing face to the shadow face; and
a projection of a starting point of the front-electrode strip in the first direction and a projection of a starting point of the back-electrode strip in the first direction coincide.

2. The solar cell according to claim 1, **characterized in that** a quantity of the front-electrode strip and a quantity of the back-electrode strip are both multiple.

3. The solar cell according to claim 2, **characterized in that** the plurality of front-electrode strips are evenly distributed on the light facing face, and the plurality of back-electrode strips are evenly distributed on the shadow face.

4. The solar cell according to claim 1, **characterized in that** a quantity of the front electrodes of the front-electrode strip is greater than or equal to a quantity of the back electrodes of the back-electrode strip.

5. The solar cell according to claim 1, **characterized in that** the plurality of back electrodes include first back electrodes and a second back electrode, wherein the first back electrodes refer to back electrodes adjacent to the starting point of the back-electrode strip, and the second back electrode refers to a back electrode provided between the first back electrodes; and
lengths of the first back electrodes and a length of the second back electrode are unequal or equal.

6. The solar cell according to claim 1, **characterized in that** among the plurality of back electrodes, spacings between two neighboring instances of the back electrodes are equal or unequal.

7. The solar cell according to claim 1, **characterized in that** a width of the front electrodes is less than or equal to a width of the back electrodes, and/or, a length of the front electrodes is less than or equal to a length of the back electrodes.

8. A solar cell panel, **characterized in that** the solar cell panel is formed by the solar cell according to any one of claims 1-7.

9. A screen printing plate, the screen printing plate being used in cooperation with the solar cell according to any one of claims 1-7, **characterized in that** the screen printing plate is provided with a printing region, the printing region is provided with a notch, and a shape of the notch matches with shapes of the back electrodes on the solar cell or shapes of the front electrodes on the solar cell.
